# EUROPEAN PATENT APPLICATION

(11) **EP 0 766 142 A1**
(43) Date of publication of application: **02.04.1997**
(21) Application number: 96113804.7
(22) Date of filing: 29.08.1996
(51) Int. Cl.: G03F 7/18, G03F 7/20

(54) **An element for making a seamless relief printing sleeve**

(30) Priority: 29.09.1995 US 536030
(71) Applicant: E.I. DU PONT DE NEMOURS AND COMPANY, Wilmington Delaware 19898 (US)
(72) Inventor: Fan, Roxy Ni, East Brunswick, New Jersey 08816 (US); Cushner, Stephen, Lincroft, New Jersey 08859 (US)
(74) Representative: Price, Anthony Stuart

(57) **Abstract**

The invention relates to a seamless cylindrical printing element which includes a cylindrical support of a polymeric film, at least one layer of a seamless photosensitive thermoplastic on the support and optionally an exterior surface of the support having an adhesion promoted surface or an adhesion layer between the support and the photosensitive layer. The invention also relates to processes for making a seamless relief printing sleeve from the element.

## Description

### BACKGROUND OF THE INVENTION

### 1. Field of the Invention

This invention relates to an element for making a seamless relief printing sleeve for use in flexographic printing.

### 2. Description of the Prior Art

Flexographic printing plates are well known for use in printing, particularly on surfaces which are soft and easily deformable, such as packaging materials, e.g., cardboard, plastic films, etc. Flexographic printing plates can be prepared from photopolymerizable compositions, such as those described in U.S. patents 4,323,637 and 4,427,749. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, polymerization, and hence, insolubilization of the photopolymerizable layer occurs in the exposed areas. Treatment with a suitable solvent removes the unexposed areas of the photopolymerizable layer leaving a printing relief which can be used for flexographic printing.

The flexographic photopolymer compositions can be formed into sheets or layers by several known methods such as solvent casting, hot pressing, calendering and extrusion. A preferred method of manufacturing flexographic printing elements is by extrusion calendering of the photopolymer composition. In extrusion calendering, the printing element is prepared by passing a mass of hot photopolymer into a extrusion die forming a layer, passing the layer into nip of a calender and, while still hot, calendering the photopolymer composition between two flat surfaces, generally two flexible films, to form a multilayer web. The films can include multiple layers or compound films. A film bearing a thin layer of flexible, polymeric film is an example of a compound film. After extrusion and calendering at elevated temperatures, the web is held in tension in the machine direction by a pair of nip rollers while the multilayer web is cooled, for example, with blown air. The printing element as a multilayer web can be cut into suitable size sheets. Extrusion and calendering of a polymeric compositions are disclosed, for example, in Gruetzmacher et al., U.S. Patent 4,427,759; and in Min, U.S. Patent 4,622,088.

Although typically photopolymeric printing elements are used in sheet form, there are particular applications and advantages to using the printing element in a continuous cylindrical form. Continuous printing elements have applications in the flexographic printing of continuous designs such as in wallpaper, decoration and gift wrapping paper. Furthermore, such continuous printing elements can be well-suited for mounting on laser exposure equipment where it can replace the drum or be mounted on the drum for exposure by a laser.

The formation of seamless, continuous printing elements can be accomplished by several methods. The photopolymerizable flat sheet elements can be reprocessed by cutting the element to wrap around a cylindrical form, (usually a printing sleeve or the printing cylinder itself), so that the edges contact without any gaps or overlapping, and fusing or joining the edges together to form a continuous element. Processes for joining the edges of a plate in into a cylindrical form have been disclosed, for example, in German patent DE 28 44 426, United Kingdom patent GB 1 579 817, and U.S. Patent 4,758,500. A problem with the prior methods of joining the edges to form the continuous cylinder is that the results of printing with the joined edge element are often unsatisfactory, particularly when the joined edge falls within the effective printing area of the plate. Although the prior art often describes the so formed continuous element as "seamless", the joined seam has not completely formed a continuum of the photopolymerizable layer at the edges since the joined seam is visible in and interrupts the printed image.

Further, photosensitive resin cylinders are also made from a layer of photopolymeric composition by a Seamex process. The Seamex process involves wrapping a layer of photopolymeric material to a nickel sleeve having a heat-activated primer coat to bond with the material so that the ends of the plate are joined together. The entire assembly is placed in an oven to cure and bond the photopolymeric layer to the primer coat and to melt the ends of the photopolymeric layer together. The photopolymeric layer on the sleeve is then ground to the necessary thickness, wiped clean and sprayed with a protective coating to prevent negatives from sticking to the photopolymer during exposure. The process of wrapping, curing and melting, grinding, and spraying the photopolymeric layer to the sleeve takes about 1.5 to 2 days to accomplish. The cylindrical photopolymeric layer on the sleeve then undergoes the steps of imagewise exposure to polymerize those areas of the layer exposed to light, and processing to wash away the unpolymerized areas of the layer on the cylinder, forming a relief surface for printing.

Also, U.S. Patent 4,337,220 discloses a process for preparing photosensitive resin cylinders which comprises winding a photosensitive resin sheet on and around the surface of a cylinder without any material overlapping of or spaces between the edge portions of the wound resin sheet, and applying to the cylinder under rotation a roll rotating in contact with the surface of the resin sheet while heating. The edge portions of the resin sheet join to one another by melting and the thickness of the resin sheet is made uniform. Preferably, the photosensitive resin sheet is wound on the cylinder with the aid of adhesive tape or agent. The resin sheet while on the cylinder is heated only in an amount sufficient for softening the resin sheet to avoid flowing of the resin because the flowing resin adheres to the roll or hangs down to make the control of the film thickness difficult.

U.S. Patent 4,869,997 discloses a process for coating plate cylinders or sleeves with a jointless, continuous, photosensitive recording layer for the production of rotary printing plates. The background of this patent states that conventional preexposure of the photosensitive recording layer from the back of recording layer wrapped on cylinders or sleeves is not possible. The sleeves may be composed of metal, e.g., nickel; plastics, or glass fiber-reinforced plastics. U.S. Patent 4,869,997 overcomes this problem by applying a photosensitive recording layer to the cylinder or sleeve in a plurality of strata in succession in which the first stratum applied is preexposed uniformly to actinic light and thereafter one or more further strata are applied without air bubbles to the first pre-exposed stratum. The individual strata are bonded together in general by heat and/or pressure, by use of hot calendering or wrapping the strata on the cylinder or sleeve with a plastic or shrink film and then heating.

U.S. Patent 4,871,650 discloses a process for coating plate cylinders or sleeves by applying a pre-fabricated solid, thermoplastically processible photosensitive layer to the cylinder or sleeve with formation of a continuous, seamless photosensitive layer under the influence of heat and pressure. The photosensitive layer is applied to the cylinder or sleeve in two or more strata without bubbles and with displacement of air between the strata, after which the total photosensitive layer material applied is heated under pressure and with joining and fusion of the individual strata. The joining or fusion of the individual strata occurs by heating under pressure until a single, cohesive continuously joined photosensitive layer is formed. The temperature is sufficiently high to allow the strata one on top of the other to fuse or flow into one another under pressure. The layer material can be heated from the back by including heaters in the cylinder or sleeve or from the outer surface of the photosensitive layer with radiators or blowers or heating from both the back and the front. Although metal sleeves such as those made of nickel can withstand such heating to join the strata, the use of polymeric films as the sleeve support can not withstand such heating without being deformed.

U.S. Patent 4,883,742 discloses a process for seamless and rim joining of the end and/or lateral areas of one or more thermoplastically processible photosensitive layers under the influence of heat and pressure for the formation of a continuous photosensitive layer. The photosensitive layers are united so that they overlap, avoiding bubbles and with displacement of the air between the end and lateral areas, the total layer material is then heated under pressure and with joining of the overlapping ends and/or lateral areas, and the layer is after treated and smoothed with shaping to size. The photosensitive layer should be solvent free or contain less than 5% by weight solvent so that the presence of the solvent does not form gas under processing conditions. The photosensitive layer is heated to a temperature which is sufficiently high to allow the overlapped end and/or lateral areas to be bonded or to flow into one another under pressure. Hereto, the layer material can be heated from the back by including heaters in the cylinder or sleeve or from the outer surface of the photosensitive layer with radiators or blowers or heating from both the back and the front.

### SUMMARY OF THE INVENTION

It is an object of the invention to provide an element for making a relief printing sleeve in which the photosensitive layer is seamless forming a continuum of the photosensitive material on the support so that the printed image is not interrupted.

It is another object of the invention to provide an element having a support and at least one photosensitive layer which is easily and quickly formed in minutes rather than days and with no substantial deformation of a polymeric support from the formation process.

Another object of the invention is to provide an element having a transparent or substantially transparent support which allows for the cylindrical element to be exposed through the support in order to establish a floor for the relief structure and to reduce the time required for overall (main) exposure.

It is still another object of the invention to provide an element having a support and at least one photosensitive layer which can be exposed and processed to be made into a relief printing sleeve without the element being mounted onto a cylinder.

Another object of the invention is to provide an element having a transparent or substantially support which can be exposed through the backing to actinic radiation to assure adhesion between the support and the at least one photosensitive layer.

Yet another object of the invention is to provide an element having a support and at least one photosensitive layer which can be readily mounted, dismounted, and remounted from a printing cylinder.

In accordance with this invention there is provided an element for making a seamless relief printing sleeve comprising:
a) a hollow cylindrical support of at least one polymeric film having a thickness of 0.010 to 2 inches and a uniform inner diameter;
b) at least one photosensitive thermoplastic seamless layer on an exterior surface of the support, the seamless layer having a thickness of 0.017 to 0.285 inches; and
c) optionally, an adhesive layer between the support and the at least one seamless layer or an exterior surface of the support having an adhesion promoting surface;
wherein the layers a), b) and c) are expandable and contractable.

In accordance with this invention there are provided processes for making a seamless relief printing sleeve from the element described above.

### BRIEF DESCRIPTION OF THE DRAWINGS

The invention can be more fully understood from the following detailed description thereof in connection with the accompanying drawing described as follows:

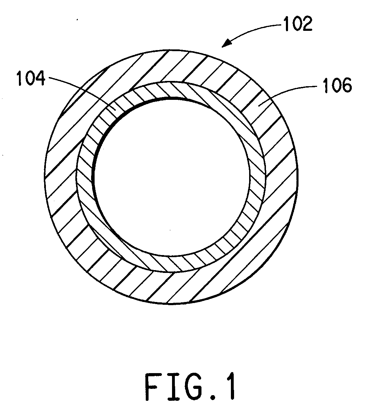

Figure 1 is a cross-sectional view of an element for making a seamless relief printing sleeve.

### DESCRIPTION OF THE PREFERRED EMBODIMENT(S)

Throughout the following detailed description, similar reference characters refer to similar elements in all figures of the drawings.

Referring to Figure 1, a cross-sectional view of the element 102 of this invention includes a support 104 and at least one seamless photosensitive thermoplastic layer 106 on the support 104. Optionally, the element 102 includes an adhesion layer (not shown) between the support 104 and the photosensitive thermoplastic layer 106 or an exterior surface of the support 104 has a adhesion promoting surface. The element 102, after backflash exposure through the support 104, imagewise exposure of an exterior surface of the photosensitive thermoplastic layer 106 and processing, forms a seamless relief printing sleeve.

For purposes of this invention, the term "seamless" as applied to the at least one photosensitive thermoplastic layer means that the photosensitive layer is a continuum of photosensitive material whereby no line of demarcation or joining of the photosensitive material as a layer or other defect influencing print quality is present at least on an outer circumferential surface, i.e., printing surfaces, of the element. Preferably, the layer of photopolymeric material is continuous throughout the thickness of the layer, i.e., radially from the exterior surface of the support to the exterior surface of the photopolymerizable layer, and along an axial length of the element. The presence or absence of a line of demarcation or joining of photosensitive material can be detected by using the element in printing tests. An example of the printing tests includes overall exposing the exterior surface of the element, essentially forming solid areas of no relief upon processing, and printing the solid areas. Any defects associated with a demarcation line or joining of the photosensitive material would be detected by such a test. Printing tests can also include formation of a relief image on the element and printing the image to check for defects.

The element includes the support of at least one polymeric film which is formed into a hollow cylinder. The support can be made of any polymeric material which is transparent or substantially transparent to actinic light, dimensionally stable and which is non-reactive and remains stable throughout the processing conditions. Actinic light includes visible and ultraviolet radiation. Examples of suitable polymeric materials include polymeric films, such those formed by addition polymers and linear condensation polymers. Linear polyesters are preferred, particularly polyethylene terephthalate (PET). Other linear, crystalline polyester films can also serve as the support, including, for example, ethylene glycol polyesters of isophthalic acid, naphthalenic acid, or mixtures of terephthalic and naphthalenic and/or isophthalic acids, or polyesters of other glycols, especially butanediol, 1,4-cyclohexane dimethanol or mixtures of ethylene glycol with butanediol. Other polymeric materials which form films and are suitable for use as the support include polystyrene and polyvinyl resins, such as, polyvinyl chloride and polyvinyl acetate. The support can have a wall thickness from 0.010 to about 2 inches (0.025 to 5.08 cm), preferably from 10 to 100 mils (0.025 to 0.25 cm). Generally, a preferred wall thickness is dependent upon the desired end-use conditions.

The support is at least one layer of polymeric film. The support made of multiple layers of polymeric materials or films may also include an adhesive layer or tape (e.g., double-side) between the layers of polymeric material. A preferred support is a multiple layered sleeve as disclosed by McConnell in U.S. Patent 5,301,610, which is hereby incorporated by reference. Other examples of a supports suitable for use in the element are disclosed by Bass et al. in U.S. Patent 3,146,709 and by Hoage et al. in U.S. Patent 4,903,597.

Fillers or reinforcing agents can be present in the polymeric material to the extent that the reinforcing agents do not interfere with the desired characteristics of the support. Examples of fillers or reinforcing agents include various fibers (synthetic, modified, or natural) e.g., cellulosic fibers for instance cotton, cellulose acetate, viscose rayon; paper; glass wool; and nylon. It should be understood that fillers and reinforcing agents can be present in the at least one polymeric film to the extent that the support is transparent or substantially transparent to actinic light.

In order for the element to be readily mounted onto a printing cylinder, the support is a hollow cylinder having a uniform inner diameter. The support is expandable and contractable since it readily and repeatably mounts and dismounts from printing cylinders. The support must be able to grip the print cylinder without slippage, i.e., elastically expandable diametrically. Typically an interference fit with the print cylinder of 3 to 15 mils is preferred. The support should be expandable with the 40 to 100 psig air generally available in printing facilities and should expand sufficiently so they are easily slid over the print cylinder, so that an expansion exceeding the amount of interference fit is required. The support should have an outer surface free from irregularities that cause printing defects and have a uniform wall thickness which results in a difference in diameter (i.e., trueness) of the outer wall surface when mounted on the print cylinder of less than 5 mils (0.013 cm) and preferably less than 1 mil (0.0025 cm).

The element includes at least one photosensitive thermoplastic seamless layer on an exterior surface of the support. Since there is at least one photosensitive thermoplastic layer on the support, the photosensitive thermoplastic layer or layers must also be able to expand and contract similar to the support in order for the element to be mounted and dismounted from the printing cylinder. Examples of photosensitive materials suitable for use as the seamless layer include materials suitable for photomechanical printing processes, photopolymerization processes, and diazotype processes, as disclosed in *Light Sensitive Systems: Chemistry and Application of Nonsilver Halide Photographic Processes,* by J. Kosar, John Wiley & Sons, Inc., New York, 1965, to the extent that these materials are also thermoplastic. A thermoplastic material will repeatedly soften when heated and harden when cooled. Particularly preferred materials for the at least one photosensitive thermoplastic seamless layer, are photopolymerizable materials.

As used herein, the term "photopolymerizable" is intended to encompass systems which are photopolymerizable, photocrosslinkable, or both. The photopolymerizable layer comprises an elastomeric binder, at least one monomer and an initiator, where the initiator has a sensitivity to actinic radiation. In most cases, the initiator will be sensitive to visible or ultraviolet radiation. Any photopolymerizable compositions which are suitable for the formation of flexographic printing plates can be used for the present invention. Examples of suitable compositions have been disclosed, for example, in Chen et al., U.S. Patent 4,323,637, Grüetzmacher et al., U.S. Patent 4,427,749 and Feinberg et al., U.S. Patent 4,894,315.

The elastomeric binder can be a single polymer or mixture of polymers which can be soluble, swellable or dispersible in aqueous, semi-aqueous or organic solvent developers. Binders which are soluble or dispersible in aqueous or semi-aqueous developers have been disclosed in Alles U.S. Patent 3,458,311; Pohl U.S. Patent 4,442,302; Pine U.S. Patent 4,361,640; Inoue et al., U.S. Patent 3,794,494; Proskow U.S. Patent 4,177,074; Proskow U.S. Patent 4,431,723; and Worns U.S. Patent 4,517,279. Binders which are soluble, swellable or dispersible in organic solvent developers include natural or synthetic polymers of conjugated diolefin hydrocarbons, including polyisoprene, 1,2-polybutadiene, 1,4-polybutadiene, butadiene/acrylonitrile, butadiene/styrene thermoplastic-elastomeric block copolymers and other copolymers. The block copolymers discussed in Chen U.S. Patent 4,323,636; Heinz et al., U.S. Patent 4,430,417; and Toda et al., U.S. Patent 4,045,231 can be used. It is preferred that the binder be present in at least an amount of 65% by weight of the photosensitive layer.

The term binder, as used herein, encompasses core shell microgels and blends of microgels and preformed macromolecular polymers, such as those disclosed in Fryd et al., U.S. Patent 4,956,252.

The photopolymerizable layer can contain a single monomer or mixture of monomers which must be compatible with the binder to the extent that a clear, non-cloudy photosensitive layer is produced. Monomers that can be used in the photopolymerizable layer are well known in the art and include but are not limited to addition-polymerization ethylenically unsaturated compounds having relatively low molecular weights (generally less than about 30,000). Preferably, the monomers have a relatively low molecular less than about 5000. Examples of suitable monomers include, but are not limited to, t-butyl acrylate, lauryl acrylate, the acrylate and methacrylate mono- and poly-esters of alcohols and polyols such as alkanols, e.g., 1,4-butanediol diacrylate, 2,2,4-trimethyl-1,3 pentanediol dimethacrylate, and 2,2-dimethylolpropane diacrylate; alkylene glycols, e.g., tripropylene glycol diacrylate, butylene glycol dimethacrylate, hexamethylene glycol diacrylate, and hexamethylene glycol dimethacrylate; trimethylol propane; ethoxylated trimethylol propane; pentaerythritol, e.g., pentaerythritol triacrylate; dipentaerythritol; and the like. Other examples of suitable monomers include acrylate and methacrylate derivatives of isocyanates, esters, epoxides and the like, such as decamethylene glycol diacrylate, 2,2-di(p-hydroxyphenyl)propane diacrylate, 2,2-di(p-hydroxyphenyl)propane dimethacrylate, polyoxyethyl-2,2-di(p-hydroxyphenyl)propane dimethacrylate, and 1-phenyl ethylene-1,2-dimethacrylate. Further examples of monomers can be found in Chen U.S. Patent 4,323,636; Fryd et al., U.S. Patent 4,753,865; Fryd et al., U.S. Patent 4,726,877 and Feinberg et al., U.S. Patent 4,894,315. It is preferred that the monomer be present in at least an amount of 5% by weight of the photopolymerizable layer.

The photoinitiator can be any single compound or combination of compounds which is sensitive to actinic radiation, generating free radicals which initiate the polymerization of the monomer or monomers without excessive termination. The photoinitiator is generally sensitive to actinic light, e.g., visible or ultraviolet radiation, preferably ultraviolet radiation. Preferably, the photoinitiator should be thermally inactive at and below 185°C. Examples of suitable photoinitiators include the substituted and unsubstituted polynuclear quinones. Examples of suitable systems have been disclosed in Grüetzmacher U.S. Patent 4,460,675 and Feinberg et al., U.S. Patent 4,894,315. Photoinitiators are generally present in amounts from 0.001% to 10.0% based on the weight of the photopolymerizable composition.

The photopolymerizable layer can contain other additives depending on the final properties desired. Such additives include sensitizers, plasticizers, rheology modifiers, thermal polymerization inhibitors, tackifiers, colorants, antioxidants, antiozonants, or fillers.

Plasticizers are used to adjust the film forming properties of the elastomer. Examples of suitable plasticizers include aliphatic hydrocarbon oils, e.g., naphthenic and paraffinic oils; liquid polydienes, e.g., liquid polybutadiene; liquid polyisoprene; polystyrene; poly-alpha-methyl styrene; alpha-methylstyrene-vinyltoluene copolymers; pentaerythritol ester of hydrogenated rosin; polyterpene resins; and ester resins. Generally, plasticisers are liquids having molecular weights of less than about 5000, but can have molecular weights upto about 30,000. Plasticizers having low molecular weight will encompass molecular weights less than about 30,000.

The thickness of the photopolymerizable layer can vary over a wide range depending upon the type of printing plate desired. For so called "thin plates" the photopolymerizable layer can be from about 17 to 67 mils (0.04 to 0.17 cm) in thickness. Thicker plates will have a photopolymerizable layer up to 100-285 mils (0.25 to 0.72 cm) in thickness or greater.

In the preferred embodiment, the photosensitive thermoplastic seamless layer is a photopolymerizable seamless layer. The at least one photopolymerizable layer is seamless in that the layer is a continuum of photopolymeric material formed from a hot melt of polymer or from a solid (i.e., cooled) photopolymeric layer which is heated to polymeric hot melt. At least the printing surface of the photopolymerizable layer is seamless, forming a continuum of photopolymeric material which is free of lines of demarcation or joining. Preferably, the layer of photopolymeric material is continuous throughout the thickness of the layer, i.e., radially from the exterior surface of the support to the exterior surface of the photopolymerizable layer, and along an axial length of the element.

The photopolymerizable layer itself can be prepared in many ways by admixing the binder, monomer, initiator, and other ingredients. It is preferred that the photopolymerizable mixture be formed into a hot melt and then calendered to the desired thickness of the layer as described in U.S. Serial No. * (IM-1036), cofiled herewith. An extruder can be used to perform the functions of melting, mixing, deaerating and filtering the composition. If it is more than one layer of photopolymerizable material is desired, a method of forming the element having more than one photopolymerizable layer is by extruding and calendering a first layer of a first photopolymerizable composition onto the exterior surface of the support and then extruding and calendering a second layer of a second photopolymerizable composition onto the first layer. The at least one photopolymerizable layer can also be prepared from a previously formed solid photopolymeric plate by heating, melting and calendering the photopolymeric layer of a plate onto the support. Thus, the solid photopolymerizable layer of the plate undergoes re-processing by a second heating and melting to hot melt and calendering to form the continuous seamless photopolymerizable layer on the support. The application of heat and pressure by calendering a solid polymeric layer to weld matched edges at the surface together is generally not sufficient to form a seamless photopolymerizable layer within the scope of this invention. For elements of the present invention, a solid photopolymerizable layer must be heated in its entirety such that the polymeric material is a hot melt and calenders to form a seamless continuum of material on the support.

Optionally, the element includes an adhesive layer between the support and the at least one seamless layer, or the exterior surface of the support has an adhesion promoting surface. The adhesive layer on the exterior surface of the support can be a subbing layer of an adhesive material or primer or an anchor layer as disclosed in U.S. Patent 2,760,863 to give strong adherence between the support and the photopolymerizable layer. The adhesive compositions disclosed in Burg, U.S. Patent 3,036,913 are also effective. Materials suitable as an adhesive layer include thermally activated adhesives, such as hot melt adhesives, and thermoplastic-elastomeric binders. Thermally activated adhesives are solid materials which soften at elevated temperatures to enable them to act as adhesives. Suitable hot melt adhesives can be found in "Handbook of Adhesives", edited by I. Skeist, second edition, Van Nostrand Reinhold Company, NY, 1977, particularly Chapters 30 and 35. Examples of hot melt adhesives include, but are not limited to, polyamides, polyacrylates, polyolefins, polyurethanes, polyisobutylenes, polyvinyl resins, polyester resins, and copolymers and blends of these and other polymers. Thermoplastic-elastomeric binders suitable for use as adhesives are the same as the elastomeric binders described for photopolymerizable layer. The coating on the support can be 40 angstrom to 40 microns thick. In addition, the exterior surface of the support can be treated to promote adhesion between the support and the photopolymerizable layer, with flame-treatment or electron-treatment, e.g., corona-treated. Further, the adhesion of the photosensitive layer to the support can be adjustable by exposing the element to actinic radiation through the support as disclosed by Feinberg et al. in U.S. Patent 5,292,617.

The element may include additional layers conventional in the art on the at least one photopolymerizable layer, such as, for example, release layers as disclosed by Chen et al., in U.S. 4,423,135, and capping layers as disclosed by Gruetzmacher et al., in U.S. Patents 4,427,759 and 4,460675. The element may also include an infrared-sensitive layer as disclosed by Fan in U.S. Patent 5,262,275. Any additional layers on the at least one seamless photosensitive thermoplastic layer should also be seamless.

### Process for Preparing a Flexographic Printing Sleeve from the Photopolymerizable Element formed:

The process of the invention includes a back exposure or backflash step. This is a blanket exposure to actinic radiation through the support. It is used to create a layer of polymerized material, or a floor, on the support side of the photopolymerizable layer and to sensitize the photopolymerizable layer. The floor provides improved adhesion between the photopolymerizable layer and the support, helps highlight dot resolution and also establishes the depth of the plate relief. The backflash exposure can take place before, after or during the other imaging steps. It is preferred that it take place just prior to the imagewise exposure to actinic radiation of the element. Any of the conventional radiation sources discussed below for the overall exposure step can be used for the backflash exposure step. Exposure time generally range from a few seconds up to a few minutes.

Another step of the process of the invention is to overall expose the photosensitive element to actinic radiation through a mask, that is imagewise exposure of the element. The type of radiation used is dependent on the type of photoinitiator in the photopolymerizable layer. The mask can be a phototool film (e.g. negative) as is conventional in the art, or can be provided in-situ by laser ablation of an infrared sensitive coating on the photopolymerizable layer as is described in U.S. Patent 5,262,275. The mask can also be formed in-situ as described by Chambers et al. in U.S. Patent 4,429,027 and by Felton et al. in European publication EP 568 841. In the phototool, dark areas of the image prevent the photopolymerizable material beneath from being exposed to the radiation and hence those areas covered by the dark areas of the phototool do not polymerize. The "clear" areas of the phototool are exposed to actinic radiation and polymerize. Similarly, the radiation-opaque material in the infrared sensitive layer which remains on top of the photopolymerizable layer prevents the material beneath from being exposed to the radiation and hence those areas covered by the radiation-opaque material do not polymerize. The areas not covered by the radiation-opaque material are exposed to actinic radiation and polymerize. Any conventional sources of actinic radiation can be used for this exposure step. Examples of suitable visible or UV sources include carbon arcs, mercury-vapor arcs, fluorescent lamps, electron flash units, electron beam units and photographic flood lamps. The most suitable sources of UV radiation are the mercury-vapor lamps, particularly the sun lamps. A standard radiation source is the Sylvania 350 Blacklight fluorescent lamp (FR 48T12/350 VL/VHO/180, 115 w) which has a central wavelength of emission around 354 nm.

The actinic radiation exposure time can vary from a few seconds to minutes, depending upon the intensity and spectral energy distribution of the radiation, its distance from the photosensitive element, and the nature and amount of the photopolymerizable composition. Typically a mercury vapor arc or a sunlamp is used at a distance of about 1.5 to about 60 inches (3.8 to 153 cm) from the photosensitive element. Exposure temperatures are preferably ambient or slightly higher, i.e., about 20°C to about 35°C.

Conventionally, imagewise exposure of the photosensitive element to actinic radiation is conducted in a vacuum eliminating the presence of atmospheric oxygen. The exposure is conducted in a vacuum to assure intimate contact between the phototool (e.g., negative) and the surface of the photopolymerizable layer and to prevent oxygen from detrimentally affecting the polymerization reactions occuring in the photopolymer layer. It is contemplated that a device to assure intimate contact of the phototool to the surface of a rotary cylinder for gravure applications could be used in the present instance to assure contact of the phototool to the cylindrical circumferential surface of the photopolymerizable layer. In the case where the mask is formed in-situ on the photopolymerizable layer, there is no need for vacuum to assure intimate contact. In the process of preparing a flexographic printing sleeve, the overall exposure step can be conducted in a vacuum, but preferably is conducted without vacuum, i.e., while the photosensitive element is in the presence of atmospheric oxygen.

Following overall exposure to actinic radiation through the mask, the element is treated by washing with a suitable developer. The treating step removes at least the photopolymerizable layer in the areas which were not exposed to actinic radiation, i.e., the non-photopolymerized areas of the photopolymer layer, and if present, the infrared-sensitive layer which was not removed during the ablation step. Development is usually carried out at about room temperature. The developers can be organic solutions, water, aqueous or semi-aqueous solutions. The choice of the developer will depend on the chemical nature of the photopolymerizable material to be removed. Suitable organic solution developers include aromatic or aliphatic hydrocarbon and aliphatic or aromatic halohydrocarbon solutions, or mixtures of such solutions with suitable alcohols. Other organic solution developers have been disclosed in published German Application 38 28 551 and in U.S. Patent 5,354,645. Suitable semi-aqueous developers usually contain water and a water miscible organic solution and an alkaline material. Suitable aqueous developers usually contain water and an alkaline material. Other suitable aqueous developer combinations are described in U.S. Patent No. 3,796,602.

Development time can vary, but it is preferably in the range of about 2 to 25 minutes. Developer can be applied in any convenient manner, including immersion, spraying and brush or roller application. Brushing aids can be used to remove the unpolymerized portions of the composition. However, washout is frequently carried out in an automatic processing unit which uses developer and mechanical brushing action to removed the unexposed portions of the element, leaving a relief constituting the exposed image and the floor.

Following solution development, the relief printing sleeves are generally blotted or wiped dry, and then dried in a forced air or infrared oven. Drying times and temperatures may vary, however, typically the plate is dried for 60 to 120 minutes at 60°C. High temperatures are not recommended because the support can shrink and distort, causing mounting and registration problems.

Most flexographic printing elements are uniformly post-exposed to ensure that the photopolymerization process is complete and that the plate will remain stable during printing and storage. This post-exposure step utilizes the same radiation source as the main exposure.

Detackification is an optional post-development treatment which can be applied if the surface is still tacky, such tackiness not generally being removed in post-exposure. Tackiness can be eliminated by methods well known in the art, such as treatment with bromine or chlorine solutions. Such treatments have been disclosed in, for example, Grüetzmacher U.S. Patent 4,400,459, Fickes et al., U.S. Patent 4,400,460 and German Patent 28 23 300. Detackification can also be accomplished by exposure to radiation sources having a wavelength not longer than 300 nm, as disclosed in European Published Patent Application 0 017927 and Gibson U.S. Patent 4,806,506.

It should understood that at present there may not be readily available commercial apparatuses for exposing (backflash and/or main exposure), processing and finishing of a cylindrical photopolymerizable element formed, however, it is within the skill in the art to develop such apparatuses suitable for the purposes of handling the cylindrically formed element given the requirements for each of the steps. For example, in overall exposing, processing and post-exposing and detackifying steps, existing apparatuses can be modified or new apparatuses developed so that the cylindrical element can be mounted on a drum or cylinder, or the cylindrical element can support itself with the use of a cone at each of its ends, during the exposure steps. While it would be understood that for the backflash exposing step, a drum may not be suitable to support the element unless the drum is transparent to actinic radiation. Examples of circular exposing devices are disclosed in U.S. Patent 3,531,200 and in German preliminary published application DT 2 603 082.

Cylindrical photopolymerizable elements can be used to particular advantage in the formation of seamless, continuous printing relief forms. Continuous printing relief forms have applications in the flexographic printing of continuous designs such as in wallpaper, decoration and gift wrapping paper.

Furthermore, such cylindrical photopolymerizable elements are well-suited for mounting on conventional rotating drum mounted equipment. Thus, imagewise exposure, overall exposure, development and any additional process steps can be performed while the element is in cylindrical form. Conducting exposure and processing steps with a cylindrical element may provide additional advantages including increased process speed, better registration and reduced or in some cases no extra mounting time, reduced press-ready time, and increased press printing speed. In particular, the cylindrical photopolymerizable element are well-suited for mounting on conventional laser exposure equipment in which the element can be mounted directly the drum or replace the drum (with, for example, cones supporting each end of the element) for the laser exposure step. Exposure by a laser offers additional advantages of digitally imaging the cylindrical photopolymerizable element by laser ablation of an infrared sensitive coating on the element as disclosed by Fan, in U.S. Patent 5,262,275, or by laser engraving of the element as disclosed by Cushner et al. in International Publications WO 93/23252 and WO 93/23253.

In addition, the continuous photopolymerizable element can be overall exposed to actinic radiation to polymerize the photopolymerizable layer, and the resulting element can be used as a thick sleeve or a sleeve with a cushion layer or as a laser engravable printing sleeve. Such a thick sleeve or cushioned element is useful for supporting another photopolymerizable layer or a relief plate in certain printing applications.

Those skilled in the art, having benefit of the teachings of the present invention as hereinabove set forth, can effect numerous modifications thereto. These modifications are to be construed as being encompassed within the scope of the present invention as set forth in the appended claims.

### EXAMPLES

The following examples are merely illustrative of the present invention and are not meant to be limiting.

### EXAMPLE 1

The following example demonstrates the process of preparing a seamless cylindrical printing relief form from a photopolymerizable layer (sheet) of a flexographic printing element using an apparatus as described in cofiled application U.S. Serial No. (IM-1036), which is hereby incorporated by reference.

### Apparatus:

The apparatus included a mandrel and three calender rolls. The mandrel had 3 rows of 7 openings drilled at an angle and equally spaced to allow air to the circumferential surface of the mandrel to facilitate the movement of a sleeve or a sleeve having a photopolymerizable layer thereto, on and off of the mandrel. The three calender rolls were made of 316 stainless steel each having a layer of Silverstone_ protective coating to provide a release surface on the calender rolls. The calender rolls were skewed 1.5 degrees relative to the mandrel. The apparatus had the following start-up conditions.

The temperature of the calender rolls was 250 to 265 °F (121.1 to 129.4 °C). The calender rolls rotated at 22.2 rpm. The gap between the surface of the calender rolls and the circumferential surface of the mandrel was about 107 mils (0.272 centimeters) when the calender rolls were in position close to the mandrel for calendering of the photopolymerizable layer. Air was being sent to the mandrel openings. The mandrel was unlocked and was permitted to rotate.

### Process to Prepare A Cylindrical Photopolymerizable Element:

A polyester sleeve, commercially available as Cyrel® Print Sleeve, made by E. I. DuPont de Nemours (Wilmington, DE) was used. The polyester sleeve was transparent to actinic light. The sleeve had an axial length of 12 in. (30.5 cm), a wall thickness of 40 mils (0.10 cm) and an inside diameter of 3.521 in. (8.9cm). The sleeve was inserted on the mandrel. The air to the mandrel was turned off.

A Cyrel® flexographic printing element, type 134HORB, was used as the photopolymerizable layer. The thickness of the photopolymerizable layer was 134 mils (0.34 cm). The element included a coversheet, a release layer on both sides of the photopolymerizable layer, and a support, all of which were removed from the element. A 6 by 10 inch (15.3 by 25.4 cm) sheet of the photopolymerizable layer was used. The size of the sheet was such that it provided enough material to cover the polyester sleeve support and to build a polymer bank with the calender rolls yet not too much to cause melted, calendered polymer to spread beyond the ends of the sleeve.

The photopolymerizable sheet was centered on the axial length of the sleeve with an end of the sheet close to a nip between one of the calender rolls and sleeve on the mandrel. Since the thickness of the photopolymerizable sheet was thicker than the gap setting, the photopolymerizable sheet was caught by the rotating calender rolls and the mandrel (with the sleeve secured to its surface) began rotating in a direction opposite to the rotation direction of the calender rolls.

The photopolymeric layer was rotated for about 3 minutes between the calender rolls and the mandrel with the sleeve on its surface to heat, soften, melt, spread, and calender the photopolymerizable layer. During this time, the sheet of photopolymerizable layer wrapped around the sleeve on the mandrel and a leading end of the sheet contacted to mate with a trailing end of the sheet.

The rotation of the calender rolls was increased to 32.4 rpm for about 2 minutes to improve the spreading and calendering of the photopolymerizable layer and to polish a surface of the photopolymerizable layer contacting the calender rolls. The rotation of the calender rolls continued until there was no additional spreading of the photopolymerizable layer and no polymer banks. Polymer banks appear as thick lines on the contacting surface of the photopolymerizable layer which are parallel to the calender rolls. In this example, polymer banks would appear as three thick lines on the surface of the photopolymerizable layer. To verify that there were no polymer banks, the gap between the calender rolls and the mandrel was opened, i.e., the calender rolls were positioned away from the mandrel, and the surface of the photopolymerizable layer was inspected.

The photopolymerizable layer adhered to the sleeve, and formed a cylindrical photopolymerizable element. The cylindrical photopolymerizable printing element had a glossy, smooth and seamless photopolymerizable layer except at the two side edges of the element due to thinning of the photopolymer at the sides. The total thickness of the sleeve and photopolymerizable layer on the sleeve was 107 mil (0.27 cm). The air to the mandrel was turned on, the calendering rolls were moved away from the mandrel, and the element was removed from the mandrel.

The element was cooled to room temperature. An outer surface of the photopolymerizable layer of the element was sprayed coated with a composition of Macromelt® 6900 polyamide in toluene/alcohol solvent to form a release layer on the photopolymerizable layer. The element was spray coated by placing the cylindrical element on a lathe which was modified to support the element and manually moving a spray head while the lathe was rotating the element. After the release layer was room dried, both side edges of the sleeve were cut, to provide a 7 inch (17.8 cm) wide (axial length) element.

### Process to Make A Cylindrical Flexographic Printing Form from The Photopolymerizable Element:

The element resulting from above was processed in-the-round to prepare a cylindrical flexographic relief form as follows.

### Apparatuses

An experimental internal in-the-round exposure unit was used to backflash the element through the sleeve. The element was supported vertically on an end inside the internal exposure unit. The internal exposure unit included two cones spaced apart from each other to support each end of the cylindrical element vertically. One of the cones was removeable so the element could be positioned in the unit. A conventional rod lamp emitting ultraviolet radiation at about 354 nm, was centrally located on one of the cones, so that the supported element surrounded the lamp. The cones rotated the element about the lamp when the lamp was on.

An experimental external in-the-round exposure unit was used to main expose (imagewise), post-expose, and light finish the cylindrical element. The external exposure unit was similar to the internal exposure unit described above except that instead of the centrally located lamp there were two sets of multiple lamps surrounding the outside periphery of the cylindrical element. The first set of multiple lamps were conventional rod lamps emitting ultraviolet radiation at about 354 nm, surrounding the supported element. The first set of multiple lamps were used for the main exposure and the post exposure steps. The second set of multiple lamps were conventional rod lamps emitting radiation less than 300 nm, surrounding the supported element. The second set of multiple lamps were used for light finishing (detackifying) the element. Each of the lamps of the first set of lamps was spaced apart at the same distance from the outside periphery of the element. Similarly, each of the lamps of the second set of lamps was spaced apart at the same distance from the outside periphery of the element, but at a different distance from the outside periphery than the first set of lamps. Hereto, the cones rotated the element during exposure by the sets of lamps. Typically, the post-exposure and light finishing steps were done at the same time since both the first set of lamps and the second set of lamps could be on at the same time.

An experimental in-the-round processor was used to washout the areas which were not exposed to actinic light, i.e., non-photopolymerized areas, of the element. The experimental processor was substantially a smaller version of a conventional rotary washout processor with an exception. Instead of a drum as used in conventional equipment to support a photopolymer plate, two spaced cones were used to support the ends of the cylindrical element in a horizontal orientation. One of the cones adjusted position to accommodate the insertion and removal of the element into the processor. The cones rotated the element while two brush-covered rollers rotated in contact with the outside periphery surface of the element.

### Process

The element was backflash exposed for 2 minutes using the experimental internal in-the-round exposure unit described above. An opaque film (goldenrod film sold by Pitman Co.) used to prevent light scattering during imagewise exposure, was inserted inside the cylindrical element and placed adjacent to the sleeve on an inner circumference of the element. Two masks each having a target image were taped to the release layer on the outside periphery surface (outside circumference) of the photopolymerizable element. An area between the two masks of about 0.5 inch (1.3 cm) wide about midway along the axial length of the element was not covered by either of the two masks.

The element with masks was exposed through the targets, i.e., imagewise, with ultraviolet light for 30 minutes using the first set of lamps in the experimental external in-the-round exposure unit described above. The goldenrod film was removed.

The exposed element was processed in the experimental in-the-round processor described above. The element was processed in the experimental processor using Optisol® developer solvent for 9 minutes and wiped dry with lint-free cloth. The exposed and developed element was dried in an oven for 1 hour at 60° C. The dried element was post-exposed and post finished (detackified) for 15 minutes using the same external in-the-round exposure unit as described above. Both the first set of lamps and the second set of lamps were used at the same time.

The resulting cylindrical flexographic relief form exhibited good adhesion of the photopolymer layer to the sleeve. Also, the photopolymer layer was photosensitive having a continuous middle solid and 10 to 90% tonal range at 150 lpi.

The cylindrical relief form was used to print on paper on a Mark Andy Press. The cylindrical relief form was mounted on an air-assisted cylinder of the press and using 93 gear tooth to adjust the meeting of the relief form to an impression roller of the press. The printing was done onto high gloss paper from Fasson (Painsville, OH) using aqueous black ink (EIC film III Dense Black, EC 9630) from Environmental Inks and Coatings (Morgan, NC) with 27 sec. Zahn cup #2, at 100 foot-per-minute web speed. The cylindrical relief form demonstrated continuous print capability as shown in the middle solid area and printed the tonal range of 10-90% at 150 lpi.

### EXAMPLE 2

The following example demonstrates the process preparing a seamless cylindrical printing relief form from a photopolymerizable layer (sheet) of a flexographic printing element using the apparatus described above in Example 1.

A cylindrical flexographic relief form was made from the same photopolymerizable layer and with the apparatus set-up and operated as described in Example 1 with the exception that the sleeve moved axially on the mandrel after the photopolymerizable layer was calendered on the sleeve. The mandrel was in the unlocked position, air was sent to the mandrel and the sleeve inserted. The air was turned off. The photopolymerizable layer was rotated between the calender rolls and the sleeve on the mandrel. After the majority of the photopolymerizable layer had a smooth even surface, the air was turned on and the mandrel was in the locked position. The element, i.e., sleeve and photopolymerizable layer, moved helically, i.e., rotationally and axially, towards the exit end of the apparatus due to the cushion of air between the sleeve and the mandrel and the skewed angle of the calender rolls. A good seamless cylindrical photopolymerizable element was demonstrated. The element was subsequently backflashed,imagewise exposed and processed in-the-round as described in Example 1. The cylindrical relief form was used to print on the press and resulted in similar printing quality.

### EXAMPLE 3

The following example demonstrates the process of preparing a seamless cylindrical printing relief form from a photopolymerizable hot melt composition using an apparatus as described in Example 1.

The apparatus was set-up and operated as described in Example 2 with the following changes. The temperature of the calender rolls was 250 °F. The calender rolls were in position close to the mandrel for calendering the photopolymerizable molten stream with a gap between the mandrel and the calender rolls of 107 mils (0.27 cm). The calender rolls were rotating at 27 rpm. The mandrel was locked into position preventing rotation. The air to the mandrel was on. A 40 mil (0.10 cm) thickness polyester sleeve (20 inches (50.8 cm)axial length) as described in Example 1 was inserted onto the mandrel, so that an end of the sleeve last on the mandrel (exit was all the way to a drive side of the apparatus and beyond the calender rolls).

A twin screw extruder, (made by Werner & Pfleiderer) was used to extrude photopolymerizable hot melt to the above calendering apparatus. The extruder did not use a die. Instead, the hot melt polymer extruded from an outlet 3/8 in. (0.95 cm) diameter in noodle form. The ingredients for the photopolymerizable hot melt were fed into the extruder.

The photopolymerizable hot melt was composed of the following ingredients wherein all percentages are by weight, unless otherwise indicated.

| | | |
|---|---|---|
| Kraton® 1102 | Polystyrene-polybutadiene-polystyrene (from Shell Chemical Co., Houston, TX) | 58.3 |
| Nisso PB-1000 | 1,2-polybutadiene (from Nippon Soda Co., Tokyo, Japan) | 13.9 |
| Polyoil 130 | Liquid polybutadiene oil (from Huels Corp., NY) | 14.6 |
| HMDA | 1,6-hexamethylenediol diacrylate | 10.0 |
| BHT | Butyrated hydroxy toluene (from Sherwin Williams) | 1.0 |
| Irgacure® 651 | 2,2-dimethoxy-2-phenylacetophenone (from Ciba-Geigy, Hawthorne, NY) | 2.0 |
| HEMA | Hydroxethylmethacrylate (Rohm and Haas) | 0.234 |
| Red Dye 346 | Neozapon® red dye (from BASF Wyandotte Corp. Holland, MI) | 0.006 |

With the sleeve being rotated on the mandrel manually, the hot melt was extruded in noodle form from the outlet onto the sleeve. The extruder was positioned such that an outlet of the extruder fed the hot melt onto the sleeve on the mandrel adjacent to a calender roll of the apparatus. The polymer was extruded at 10 lbs/hr (4.54 kg/hr) at a temperature of about 120 °C. Once the gap between the sleeve and the calender rolls was filled with the photopolymerizable hot melt, the coated sleeve turned on its own and manual rotation was no longer required. The air was on during the run to allow easy turning and advancing of the sleeve towards the exit end of the apparatus. The coated sleeve was traveling at an axial advancing rate of about 6 inches/minute (15.24 cm/min), taking about 3 minutes to coat 18 inches (45.7 cm) of the sleeve and form the element.

A good seamless, continuous cylindrical photopolymerizable element was obtained. A "barber pole" or spiral winding appearance was observed in the resulting photopolymerizable layer on the sleeve. This element was spray coated with a polyamide release layer as described in Example 1.

The resulting element was backflashed, imagewise exposed, developed, dried and post-treated as described in Example 1. Good relief images were obtained. No defects (solid or dots) were observed due to the "barber pole" appearance.

The cylindrical flexographic printing form was used to print on the Mark Andy press as described in Example 1. The press sheet did not exhibit any defects relating to the "barber pole" appearance. Apparently, this appearance is only an optical effect. Seamless printing was obtained as desired.

### EXAMPLE 4

The following example demonstrates the process of preparing a seamless cylindrical printing relief form from a photopolymerizable hot melt composition different from that described in Example 3, using an apparatus as described in Example 1..

The apparatus was set-up and operated as described in Example 3 with the following changes. The temperature of the calender rolls was 275 °F (135 °C). The calender rolls were rotated at 28.6 rpm and the photopolymerizable hot melt feed rate from the extruder was 12 lb/hr (5.4 kg/hr).

The photopolymerizable hot melt was composed of the following ingredients wherein all percentages are by weight, unless otherwise indicated.

| | | |
|---|---|---|
| Kraton® 2105 | Polystyrene-polybutadiene-polystyrene block copolymer (from Shell Chemical Co., Houston, TX) | 61.5 |
| Cariflex DX-1000 | Styrene/butadiene diblock elastomer (from Shell Chem.) | 10.5 |
| HMDA | 1,6-hexamethylenediol diacrylate | 6.5 |
| HEMA | Hydroxethylmethacrylate (Rohm and Haas) | 0.23 |
| Polyoil | 1,4-polybutadiene, Molecular weight 3000 (from Huels Corp., NY) | 18.8 |
| Irgacure® 651 | 2,2-dimethoxy-2-phenylacetophenone (from Ciba-Geigy, Hawthorne, NY) | 1.41 |
| BHT | Butylated hydroxytoluene (from Sherwin Williams) | 0.50 |
| Red Dye 335 | Neozapon® red dye (from BASF Wyandotte Corp. Holland, MI) | 0.006 |
| TAOBN® | 1,4,4-trimethyl-2,3-diazobicyclo (3.2.2) non-2-ene-2,3-dioxide | 0.024 |

The resulting cylindrical photopolymerizable element also had "barber pole" or "spiral winding" appearance. The element was backflash and imagewise exposed, processed and printed as described in Example 3. The barber pole appearance did not cause problems in photoimaging and printing steps and seamless printing was demonstrated.

### EXAMPLE 5a

The following examples 5a and 5b, demonstrate the process of preparing a cylindrical flexographic element from a photopolymerizable hot melt composition of Example 3 using the apparatus as described in the prior Examples which had been modified to use less than three calender rolls.

Example 3 was repeated except that only two calender rolls were used to calender the photopolymerizable hot melt. One of the three calender rolls remained in the open position when the other two calender rolls were positioned close to the mandrel at the gap setting. A good seamless cylindrical photopolymerizable element was successfully made.

### EXAMPLE 5b

Example 3 was repeated except that only one calender rolls was used to calender the photopolymerizable hot melt. Two of the three calender rolls remained in the open position when the other one calender roll was positioned close to the mandrel at the gap setting. A good seamless cylindrical photopolymerizable element was successfully made.

### EXAMPLE 6

Example 3 was repeated to demonstrate the process of preparing cylindrical photopolymerizable element having a thick photopolymerizable layer from a photopolymerizable hot melt composition.

The apparatus was set-up and operated as described in Example 3 with the following changes. The temperature of the calender rolls was 225 °F (107 °C). The hot melt was extruded at a feed rate of 20 lb/hr (9.1 kg/hr). The calender rolls to mandrel were positioned at the gap setting of 165 mils (0.42 cm) (closed position) just prior to the feeding of the hot melt. A polymer ring (about one inch wide and 125 mil thickness (0.32 cm)) was placed at the end of the sleeve closest to the exit end of the apparatus while on the mandrel. The polymer ring provided contact between the calender rolls and the sleeve so that initially the sleeve would rotate without manual operation. The calender rolls were closed just prior to the feeding of the hot polymer.

A cylindrical photopolymerizable element having a thickness of 165 mils (0.42 cm), which is the thickness of the photopolymerizable layer and the sleeve, was successfully demonstrated.

### EXAMPLE 7

The following example demonstrates the process of preparing a cylindrical photopolymerizable element from a photopolymerizable hot melt composition different from that described in Examples 3 and 4.

The apparatus set-up and operation were the same as described in Example 3 except that the hot melt feed rate from the extruder was 20 lb/hr (9.1 kg/hr) and the temperature of the calender rolls was 275 °F (135 °C). The gap between the calender rolls and the mandrel was 165 mil (0.42 cm).

The photopolymerizable hot melt was composed of the following ingredients wherein all percentages are by weight, unless otherwise indicated.

| | | |
|---|---|---|
| Kraton® 1107 | Linear styrene-isoprene-styrene block copolymer (from Shell Chemical Co.) | 72.64 |
| LIR 30 | Liquid polyisoprene (from Kuraray Chemical Co., Tokyo, Japan) | 7.9 |
| Piccotex® 100S | Substituted polystyrene | 5.79 |
| Ceresin Wax | Hydrocarbon wax | 0.97 |
| HMDA | 1,6-hexamethylenediol diacrylate | 5.09 |
| HMDMA | 1,6-hexamethylenediol diacrylate | 3.57 |
| HEMA | Hydroxethylmethacrylate | 0.17 |
| Red dye | Neozapon® red dye | 0.004 |
| Irgacure® 651 | 2,2-dimethoxy-2-phenylacetophenone | 1.94 |
| BHT | Butyrated hydroxy toluene | 1.92 |

A cylindrical photopolymerizable element having a thickness of 165 mils (0.42 cm), which is the thickness of the photopolymerizable layer and the sleeve, was successfully demonstrated.

### EXAMPLE 8a

The following examples 8a and 8b demonstrate the process of preparing a cylindrical photopolymerizable element from a photopolymerizable hot melt composition having multiple photopolymerizable layers using an apparatus as described in the Description of the Preferred Embodiment(s).

A cylindrical photopolymerizable element of 107 mil (0.27 cm) (including the thickness of the sleeve) was made according to Example 3.

A second photopolymerizable layer was formed on the element by modifying the apparatus as follows. The apparatus set-up and operation was the same as Example 3 except that the temperature of the calender rolls was 275 °F (135 °C) and the calender rolls rotated at 25.4 rpm. The element was inserted onto the mandrel while air was sent to the mandrel. The gap between the calender rolls and the mandrel was set at 165 mil (0.42 cm). The hot melt composition of Example 7 was extruded in noodle form onto the previously formed cylindrical photopolymerizable layer. The second photopolymerizable layer was a different composition than the first photopolymerizable layer.

A good cylindrical photopolymerizable element having multiple photopolymerizable layers was successfully made.

### EXAMPLE 8b

Example 8a was repeated except that the cylindrical photopolymerizable element made according to Example 3 was given an overall exposure to ultraviolet light for 15 minutes before inserting the element onto the mandrel. The hot melt composition of Example 7 was extruded onto the exposed element as described in Example 8a.

A good cylindrical photopolymerizable element having a photopolymerizable layer on an exposed photopolymer layer was successfully made.

### Example 9

A photopolymerizable element was prepared as described in Example 1 except that the photopolymeric layer on the sleeve was not coated with a release layer. An exterior surface of the photopolymerizable layer on the sleeve was tacky to the touch.

The element was backflashed exposed on the internal in-the-round exposure unit and overall exposed without a mask on the external in-the-round exposure unit described in Example 1 for 30 minutes using both ultraviolet radiation and finishing light simultaneously. The surface of the photopolymerized layer of the cylindrical printing form was tack-free.

This printing form can be used either as a cushion layer for another photopolymerizable layer mounted thereto as in thick printing sleeve applications. This printing form can also be imagewise and digitally engraved with a laser, preferably a carbon dioxide laser, as is disclosed by Cushner et al. in International Publications WO 93/23252 and WO 93/23253.

### EXAMPLE 10

The following example demonstrates preparation of an cylindrical photopolymerizable element with a polyester sleeve having a thermal adhesive layer on the exterior surface of the sleeve. Example 1 was repeated with the following exceptions. Instead of the Silverstone® protective layer, a Teflon® sleeve shrunk on each of the calender rolls. The polyester sleeve was 40 mils (0.10 cm) thick, and was made according to the description of McConnell in U.S. Patent 5,301,610 except that an adhesive layer of polyethylene and polypropylene copolymer was oriented on the outside surface of the sleeve. The photopolymerizable layer was from a Cyrel® flexographic printing element was 67 mils (0.17 cm) thick.

A seamless photopolymerizable element with good adhesion of the photopolymerizable layer to the sleeve was obtained.

## Claims

1. An element for making a seamless relief printing sleeve comprising:
a) a hollow cylindrical support of at least one polymeric film having a thickness of 0.010 to 2 inches and a uniform inner diameter;
b) at least one photosensitive thermoplastic seamless layer on an exterior surface of the support, the seamless layer having a thickness of 0.017 to 0.285 inches; and
c) optionally, an adhesive layer between the support and the at least one seamless layer or an exterior surface of the support having an adhesion promoting surface;
wherein the layers a), b) and c) are expandable and contractable.

2. The element of Claim 1 wherein the support is transparent or substantially transparent to actinic light whereby the element can be exposed to the actinic light through the support.

3. The element of Claim 1 further comprising a seamless release layer on an exterior surface of the at least one seamless layer.

4. The element of Claim 1 further comprising a seamless infrared sensitive layer on an exterior surface of the at least one seamless layer.

5. The element of Claim 1 comprising at least two seamless layers wherein the seamless layer on the exterior of the support comprises the photosensitive thermoplastic material, and wherein the other seamless layer is an outermost layer forming an exterior surface of the element and comprises photopolymerizable material.

6. A process for making a seamless relief printing sleeve from an element comprising:
a) a hollow cylindrical support of at least one polymeric film having a thickness of 0.010 to 2 inches and an uniform inner diameter, wherein the support is transparent or substantially transparent to actinic light;
b) at least one photosensitive thermoplastic seamless layer on an exterior surface of the support, the seamless layer having a thickness of 0.017 to 0.285 inches; and
c) optionally, an adhesive layer between the support and the at least one seamless layer or an exterior surface of the support having an adhesion promoting surface;
wherein the layers a), b) and c) are expandable and contractable;
the process comprising;
(1) backflash exposing the element to actinic radiation through the support;
(2) providing a mask image on an exterior surface of the seamless layer;
(3) exposing imagewise the seamless layer to actinic radiation through the mask; and
(4) treating the product of step (3) with a developer solution to selectively remove imagewise areas of the seamless layer.

7. The process of Claim 13 further comprising a post-exposure step after step (4).

8. The process of Claim 13 further comprising a detackification treatment after step (4).

9. The process of Claim 15 wherein the detackification treatment comprises exposure to light having a wavelength less than 300 nm.

10. A process for making a seamless relief printing sleeve from an element comprising:
a) a hollow cylindrical support of at least one polymeric film having a thickness of 0.010 to 2 inches and an uniform inner diameter, wherein the support is transparent or substantially transparent to actinic light;
b) at least one photosensitive thermoplastic seamless layer on an exterior surface of the support, the seamless layer having a thickness of 0.017 to 0.285 inches; and
c) optionally, an adhesive layer between the support and the at least one seamless layer or an exterior surface of the support having an adhesion promoting surface;
wherein the layers a), b) and c) are expandable and contractable;
the process comprising;
(1) backflash exposing the element to actinic radiation through the support;
(2) overall exposing an exterior surface of the seamless layer to actinic radiation; and
(3) imagewise engraving the exterior surface of the seamless layer to form a relief image in the at least one seamless layer.
